# EUROPEAN PATENT APPLICATION

(11) **EP 1 713 022 A1**
(43) Date of publication of application: **18.10.2006**
(21) Application number: 05805312.5
(22) Date of filing: 27.10.2005
(51) Int. Cl.: G06K 19/07

(54) **ANTENNA ASSEMBLY AND WIRELESS COMMUNICATION SYSTEM EMPLOYING SAME**

(30) Priority: 15.03.2005 JP 2005072534; 08.01.2004 JP 2004323365
(71) Applicant: MATSUSHITA ELECTRIC INDUSTRIAL CO., LTD., Osaka 571-8501 (JP)
(72) Inventor: SASAGAWA, Misako, Chuo-ku, Osaka-shi, Osaka 540-6319 (JP); IGUCHI, Akihiko, Chuo-ku, Osaka-shi, Osaka 540-6319 (JP); SATOH, Yuki, Chuo-ku, Osaka-shi, Osaka 540-6319 (JP)
(74) Representative: Grünecker, Kinkeldey, Stockmair & Schwanhäusser Anwaltssozietät
(86) International application number: PCT/JP2005/019748
(87) International publication number: WO 2006/049068

(57) **Abstract**

An antenna device comprising: a substrate; a ground conductor provided on the bottom surface of the substrate; a radiation conductor, with a partial cutout, provided on the top surface of the substrate; a ground terminal provided on the partial cutout of the radiation conductor; a conductor connecting the ground conductor with the ground terminal; and a feed terminal connected to the radiation conductor, wherein the ground terminal and the feed terminal are connected via an IC chip is provided. The configuration can realize an antenna device capable of feeding electric power through the IC chip, and of operating even on a metal plate fully well. A radio communication system using the antenna device is provided additionally.

## Description

### TECHNICAL FIELD

The present invention relates to an antenna device for use in radio-communication system.

### BACKGROUND ART

The RFID (Radio Frequency Identification) system, an example of radio-communication system, is a generic term referring to an identification technology utilizing radio waves. In recent years, the contactless communication system by radio waves in combination with identification technology utilizing IC chip has become a mainstream in the field. Specifically, a device called a reader/writer retrieves data stored in an IC chip embedded in tag or label shaped antenna attached on persons or objects to identify the persons or the objects.

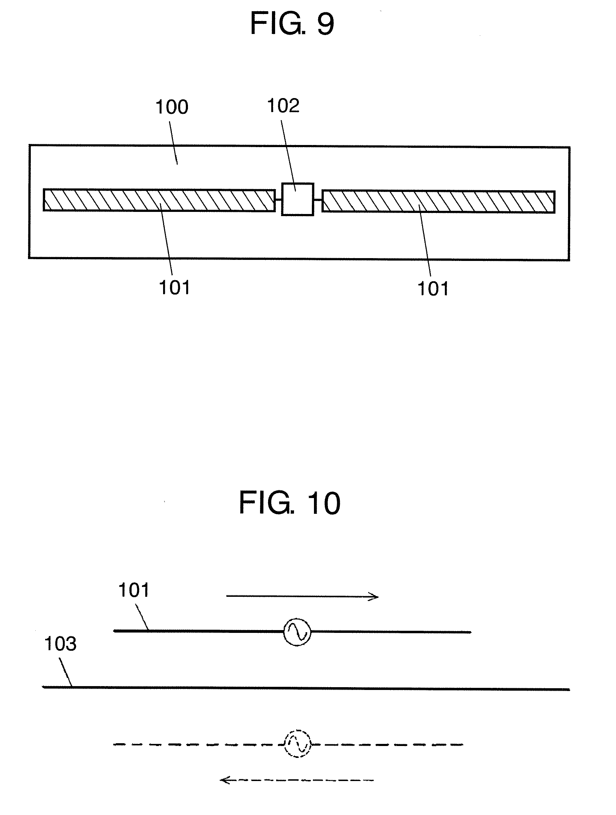

Japanese Patent Unexamined Publication No. 2004-104344 discloses an example of an antenna for the RFID tag. A conventional dipole antenna is described with reference to FIG. 9. The dipole antenna shown in FIG. 9 comprises dielectric sheet 100, radiation element 101 and IC chip 102, wherein IC chip 102 feeds electric power to radiation element 101.

However, when the tag is attached on a metal plate to communicate data a problem occurs that the antenna in the tag doesn't function well owing to an influence from the metal plate. Specifically, when the dipole antenna is located near metal plate 103, a reverse phase current directing opposite to the current flowing in radiation element 101 is generated through metal plate 103. The both currents will weaken each other in far-field consequently, causing interference in radiation from radiation element 101 and thereby causing a problem of decrease in antenna characteristics.

### SUMMARY OF THE INVENTION

The present invention provides an antenna device comprising: a substrate; a ground conductor provided on the bottom surface of the substrate; a radiation conductor, with a partial cut-out, provided on the top surface of the substrate; a ground terminal provided on the partial cut-out in the radiation conductor; a conductor connected between the ground conductor and ground terminal; and a feed terminal connected to the radiation conductor, wherein the ground terminal and the feed terminal are connected via an IC chip. The configuration can mount the IC chip on the surface of the antenna device easily, and can feed electric power through the IC chip. Moreover, the ground conductor provided on the bottom surface of the substrate allows the antenna device to be hardly influenced by a metal plate when disposed on the metal plate, which can prevent a decrease in antenna characteristics. As a result, the present invention provides the antenna device that can perform fully well even on a metal plate.

Additionally, the present invention provides a radio communication system with the aforementioned antenna device for use in being disposed on a metal.

### BRIEF DESCRIPTION OF THE DRAWINGS

FIG. 1A shows a perspective view of the antenna device used in the preferred embodiment of the present invention.
FIG. 1B shows an enlarged view of the mounted IC chip shown in FIG. 1A.
FIG. 2A shows a perspective view of the antenna device used in another preferred embodiment of the present invention.
FIG. 2B shows an enlarged view of the mounted IC chip shown in FIG. 2A.
FIG. 3 shows a perspective view of the antenna device used in the other preferred embodiment of the present invention.
FIG. 4A shows a perspective view of the antenna device used in the other preferred embodiment of the present invention.
FIG. 4B shows a perspective view of the antenna device used in the other preferred embodiment of the present invention.
FIG. 5 shows a perspective view of the antenna device used in the other preferred embodiment of the present invention.
FIG. 6A shows a perspective view of the antenna device used in the other preferred embodiment of the present invention.
FIG. 6B shows a perspective view of the antenna device used in the other preferred embodiment of the present invention.
FIG. 7 shows a perspective view of the antenna device used in the other preferred embodiment of the present invention.
FIG. 8A shows a perspective view of the antenna device used in the other preferred embodiment of the present invention.
FIG. 8B shows a perspective view of the antenna device used in the other preferred embodiment of the present invention.
FIG. 9 shows a structural view of a conventional antenna device.
FIG. 10 shows a schematic view to explain the principle of operation of the conventional antenna device .

### [Reference Numerals]

- 1: antenna device
- 2: substrate
- 3: ground conductor
- 4: radiation conductor
- 5: ground terminal
- 6: conductor
- 7: feed terminal
- 8: IC chip

### DETAILED DESCRIPTION OF THE PREFERRED EMBODIMENT

An example used in the preferred embodiment of the present invention is described with reference to the drawings. The drawings are shown schematically and positions are not shown correctly in dimensions. The present invention shall not be limited to the preferred embodiment.

### (Preferred embodiment)

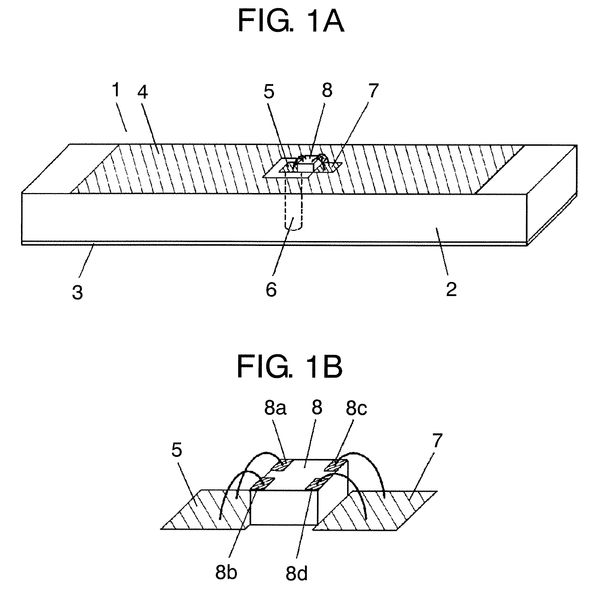

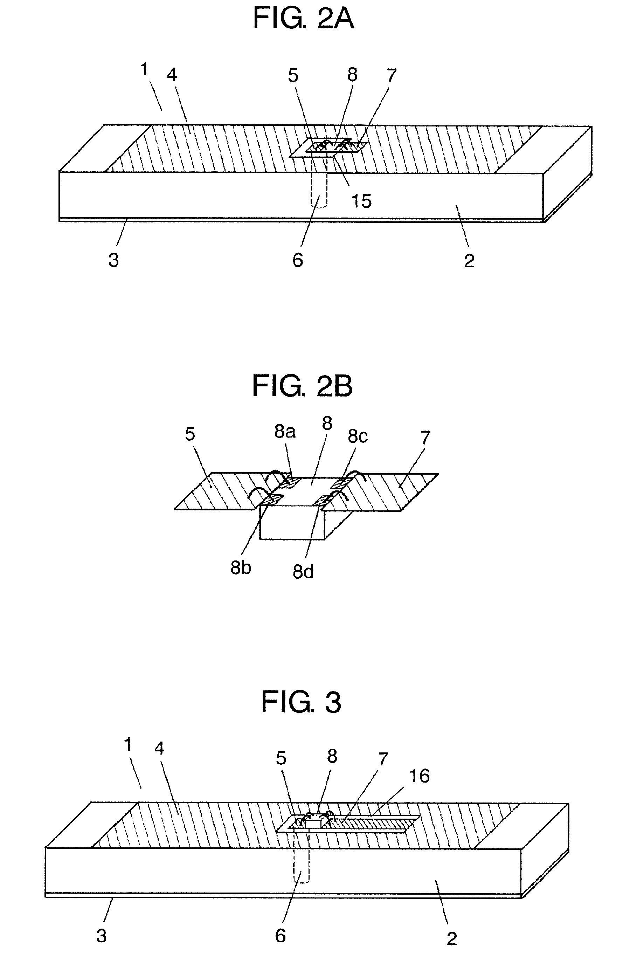

FIG. 1A shows a perspective view of antenna device 1 of the present invention. Antenna device 1 comprises; substrate 2; ground conductor 3 provided on the bottom surface of substrate 2; radiation conductor 4, with a partial cut-out, provided on the top surface of substrate 2; ground terminal 5 provided in the partial cut-out of radiation conductor 4; conductor 6 connected between ground terminal 5 and ground conductor 3; and feed terminal 7 connected to radiation conductor 4. Conductor 6 connects ground conductor 3 with ground terminal 5 electrically and is formed for instance by through-hole or the like. IC chip 8 is mounted between ground terminal 5 and feed terminal 7. Ground electrodes 8a and 8b of IC chip 8 are connected to ground terminal 5, and ground electrodes 8c and 8d to feed terminal 7 respectively by for instance wire bonding or the like as shown in FIG. 1B. In this way, electric energy is fed to radiation conductor 4. To protect IC chip 8 and mounted parts, outer surface of chip 8 should preferably be covered by a resin dielectric or the like. IC chip 8 can be provided embedded in dent 15 formed between ground terminal 5 and feed terminal 7 as shown in FIG. 2A. As IC chip 8 that would otherwise be a protrusion on the surface of radiation conductor 4 can be thus housed into substrate 2 as shown in FIG. 2B, then antenna device 1 can be provided with a flat surface. Additionally, as the housed component into substrate 2 is just IC chip 8, the distance between ground conductor 3 and radiation conductor 4 that has effects on the antenna characteristics is not necessary to change, enabling antenna device 1 to realize excellent characteristics. Generally, the resonance frequency of an antenna is determined by the length of radiation conductor 4. Antenna device 1 in the present invention utilizes a mode to operate when the length of radiation conductor 4 is approximately λ/2. Where, X means the wavelength of the resonance frequency. Although the width of radiation conductor 4 has little influence on the resonance frequency, a large width is preferable as a wider radiation conductor can transmit radio waves easier. Antenna device 1 with the aforementioned configuration operates utilizing the magnetic currents generated between ground conductor 3 and radiation conductor 4. Ground conductor 3 when disposed on a metal plate acts as if it is changed in size, causing little influence on the antenna characteristics. Additionally, as the configuration can provide directivity on the side of radiation conductor 4, antenna 1 has a feature to limit communication area easily.

Slit 16 provided between radiation conductor 4 and feed terminal 7 as shown in FIG. 3 performs as an inductance element loaded between radiation conductor 4 and feed terminal 7 equivalently, thereby operating the slit as a matching circuit. Therefore, as an impedance matching with IC chip 8 becomes possible instead of using any chip component additionally, electric power can be fed to radiation conductor 4 efficiently to realize the antenna device with excellent characteristics. Of the order of 0.5 mm width will be enough for the slit.

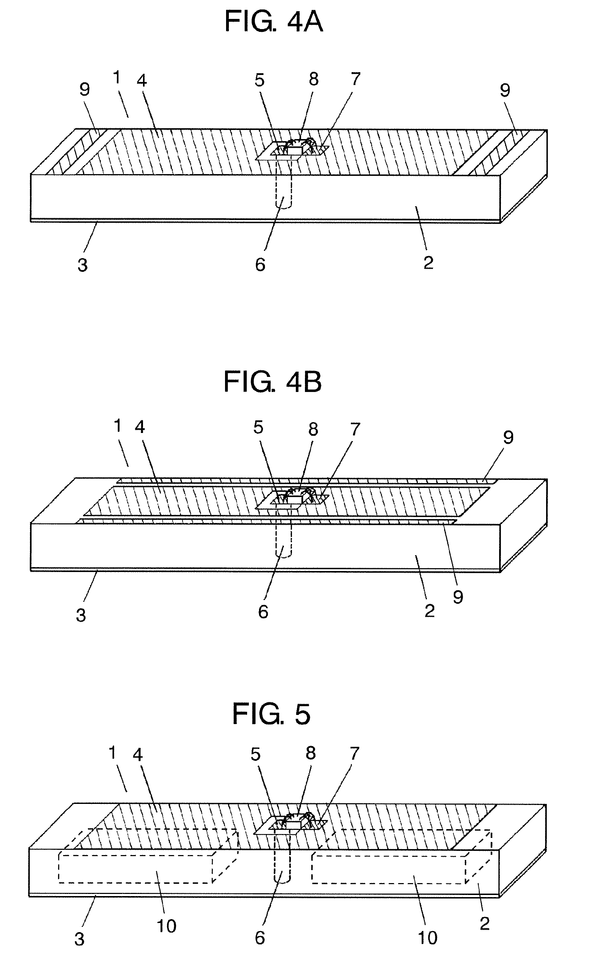

Parasitic conductors 9 electrically insulated from radiation conductor 4 disposed on the surface of substrate 2 as shown in FIGS. 4A and 4B generate an electro-magnetic field coupling between radiation conductor 4 and parasitic conductor 9, enabling antenna device 1 to operate in a broader bandwidth. Moreover, antenna device 1 can control directivity when parasitic conductor 9 is operated as a reflector.

As ground conductor 3 and radiation conductor 4 are disposed facing each other, antenna device 1 functions as a capacitor equivalently. If substrate 2 is produced using a high dielectric constant material, Q-value (Q-value in a resonance circuit) between ground conductor 3 and radiation conductor 4 would increase, causing a decrease in bandwidth or in directivity. Substrate 2, therefore, should preferably be produced by using a low dielectric constant material or be provided with cavities 10 as shown in FIG. 5. Cavity 10 functions to decrease an effective dielectric constant of substrate 2, and can prevent decrease in antenna characteristics.

Substrate 2 produced by using a flexible material would provide antenna device 1 capable of attaching even on a curved metal plate easily such as for instance on a car hood or the like. The similar result will be given on metal materials other than iron such as for instance aluminum or copper. The flexible material can be any material that cannot be broken by bending. The loss in high frequency range of the material should preferably be little. For example, fluorocarbon resin or the like is required.

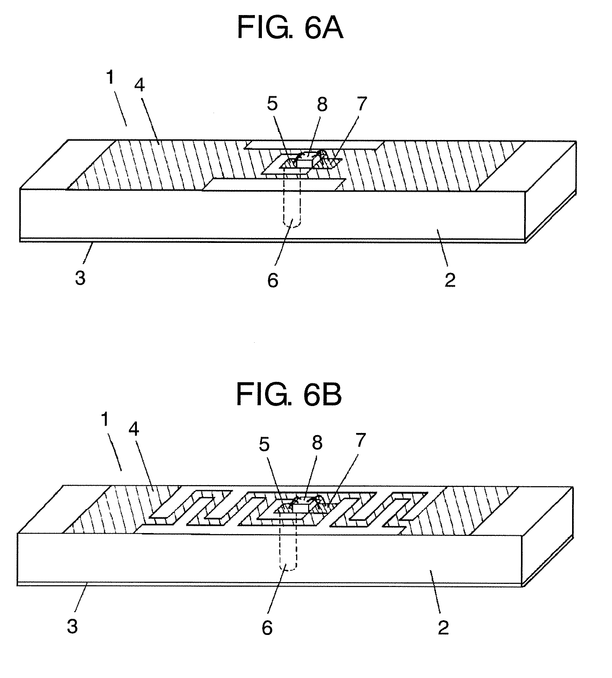

Although radiation conductor 4 is provided with a constant width longitudinally in the preferred embodiment, a different configuration may be acceptable such as narrower in the central portion and wider in both open ends as shown in FIG. 6A. As the impedance varies at the portion of different widths of radiation conductor 4, the electrical length can be controlled, which can realize a downsized radiation conductor 4. Meandering line or spiral shaped central portion as shown in FIG. 6B would provide similar effects.

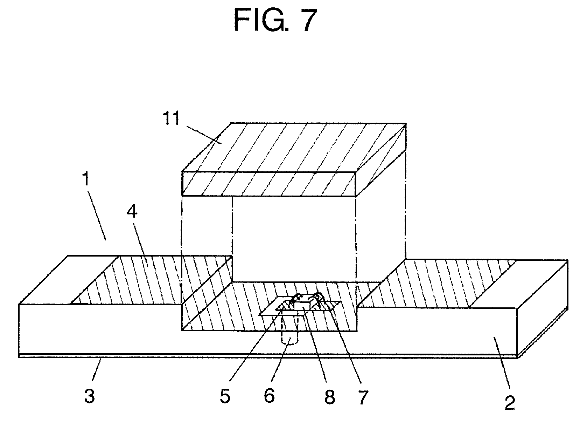

Although radiation conductor 4 is provided with a constant height from the bottom or to be planar longitudinally in the preferred embodiment, substrate 2 may have a step down in the surface on which mounted parts of IC chip 8 including ground terminal 5 and feed terminal 7, and a portion of radiation conductor 4 are disposed as shown in FIG. 7. As radiation conductor 4 is formed also on the step portion, the directivity can be under control and the distance between the open end of radiation conductor 4 and ground conductor can be fully utilized to provide antenna device 1 with excellent characteristics. Molding the step portion by dielectric 11 can protect IC chip 8 and the mounted portion.

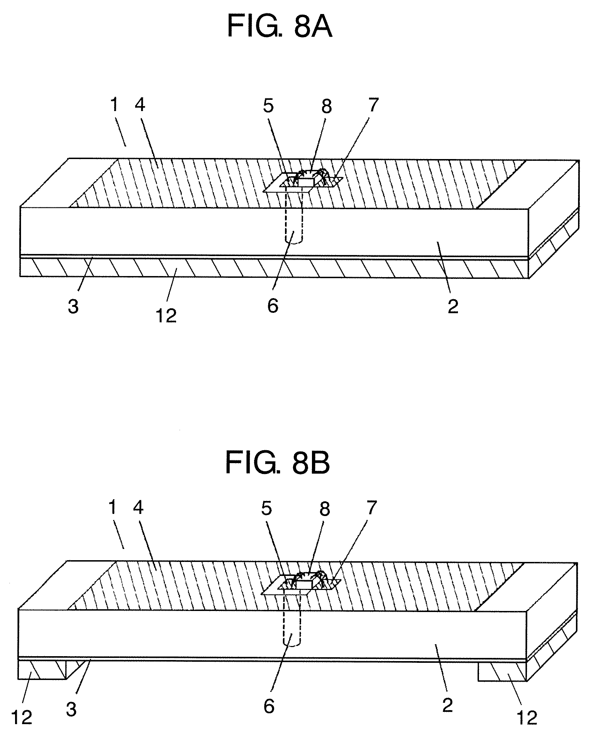

The entire surface of ground conductor 3 can be covered with insulation layer 12 as shown in FIG. 8A. When disposed on a metal via insulation layer 12, antenna device 1 will be able to radiate radio waves not only from radiation conductor 4 but also from ground conductor 3, enabling to improve the communication characteristics. When provided on both end portions only of ground conductor 3 as shown in FIG. 8B insulation layers 12 can also give similar effects. With an adhesive material used for insulation layer 12, antenna device 1 will be attached easily on a metal or the like, increasing in convenience for antenna device 1. ABS resin or FR4 substrate can be used for materials for the insulation layer.

### INDUSTRIAL APPLICABILITY

The present invention provides an antenna device that can mount an IC chip on the surface easily, and can hardly be influenced from a metal plate when disposed on the metal plate.

## Claims

1. An antenna device comprising
a substrate;
a ground conductor provided on the bottom surface of the substrate;
a radiation conductor, with a partial cutout, provided on the top surface of the substrate;
a ground terminal provided in the partial cutout of the radiation conductor;
a conductor to connect the ground conductor with the ground terminal;
and
a feed terminal connected to the radiation conductor, wherein the ground terminal and the feed terminal are connected to an IC chip.

2. The antenna device of claim 1, wherein a slit is provided between the radiation conductor and the feed terminal.

3. The antenna device of claim 1, wherein a width of the radiation conductor differs between in a central portion and in both broad sides.

4. The antenna device of claim 1, wherein the radiation conductor is formed meandering in the central portion and flat in both broad sides.

5. The antenna device of claim 1, wherein the radiation conductor is formed spiral in the central portion and flat in both broad sides.

6. The antenna device of claim 1, wherein a dent is formed between the ground terminal and the feed terminal, and the IC chip is embedded in the dent.

7. The antenna device of claim 1, wherein a step is provided on a surface of the substrate, and mounted parts of the IC chip including the ground terminal and the feed terminal, and a portion of radiation conductor are disposed on the step.

8. The antenna device of claim 7, wherein the step is molded by a dielectric.

9. The antenna device of claim 1, wherein the substrate is provided with cavities internally.

10. The antenna device of claim 1, wherein parasitic conductors electrically insulated from the radiation conductor are disposed on the substrate.

11. The antenna device of claim 1, wherein the substrate is formed from a flexible material.

12. The antenna of claim 1, wherein an insulation layer is provided on one of an entire surface of the ground conductor and a portion of the ground conductor.

13. A radio communication system having one of the antenna device of claim 1 to 12 to dispose on a metal.

## Amended claims

### Amended claims under Art. 19.1 PCT

1. (Amended) An antenna device comprising:
a substrate;
a ground conductor provided on the bottom surface of the substrate;
a radiation conductor, with a partial cutout, provided on the top surface of the substrate;
a ground terminal provided in the partial cutout of the radiation conductor;
a conductor to connect the ground conductor with the ground terminal;
and
a feed terminal connected to the radiation conductor, wherein the ground terminal and the feed terminal are connected to an IC chip, and a slit is provided between the radiation conductor and the feed terminal.

2. (deleted)

3. The antenna device of claim 1, wherein a width of the radiation conductor differs between in a central portion and in both broad sides.

4. The antenna device of claim 1, wherein the radiation conductor is formed meandering in the central portion and flat in both broad sides.

5. The antenna device of claim 1, wherein the radiation conductor is formed spiral in the central portion and flat in both broad sides.

6. The antenna device of claim 1, wherein a dent is formed between the ground terminal and the feed terminal, and the IC chip is embedded in the dent.

7. The antenna device of claim 1, wherein a step is provided on a surface of the substrate, and mounted parts of the IC chip including the ground terminal and the feed terminal, and a portion of radiation conductor are disposed on the step.

8. The antenna device of claim 7, wherein the step is molded by a dielectric.

9. The antenna device of claim 1, wherein the substrate is provided with cavities internally.

10. The antenna device of claim 1, wherein parasitic conductors electrically insulated from the radiation conductor are disposed on the substrate.

11. The antenna device of claim 1, wherein the substrate is formed from a flexible material.

12. The antenna device of claim 1, wherein an insulation layer is provided on one of an entire surface of the ground conductor and a portion of the ground conductor.

13. A radio communication system having one of the antenna device of claim 1 to 12 to dispose on a metal.
